## Europäisches Patentamt

(19) **European Patent Office**

**Office européen des brevets**

(11) Publication number: **0 127 265**
**B1**

(12) EUROPEAN PATENT SPECIFICATION

(45) Date of publication of patent specification: **04.01.89**

(51) Int. Cl.⁴: **G 05 D 23/20, F 25 B 49/00**

(21) Application number: **84301388.9**

(22) Date of filing: **02.03.84**

(54) Control of chilled water temperature.

(30) Priority: **26.05.83 US 498376**

(43) Date of publication of application:
**05.12.84 Bulletin 84/49**

(45) Publication of the grant of the patent:
**04.01.89 Bulletin 89/01**

(84) Designated Contracting States:
**DE FR GB IT**

(56) References cited:
FR-A-2 446 511
US-A-4 327 559

ADVANCES IN INSTRUMENTATION, vol. 38,
October 1983, part 2, pages 1137-1149, ISA,
Research Triangel Park, NC, US; L.L.
ENTERLINE et al.: "Chiller optimization by
distributed control to save energy"
PATENTS ABSTRACTS OF JAPAN, vol. 7, no.
16 (M-187)1161r, 22th January 1983; & JP - A -
57 172 127 (HITACHI SEISAKUSHO K.K.) 22-10-
1982

(73) Proprietor: THE BABCOCK & WILCOX
COMPANY
1010 Common Street P.O. Box 60035
New Orleans Louisiana 70160 (US)

(72) Inventor: Kaya, Azmi
2365 Woodpark Road
Akron Ohio 44313 (US)
Inventor: Willey, Michael Scott
8653 Apple Hill Road
Chagrin Falls Ohio 44022 (US)

(74) Representative: Cotter, Ivan John et al
D. YOUNG & CO. 10 Staple Inn
London WC1V 7RD (GB)

## Description

This invention relates to arrangements for and methods of controlling the temperature of chilled water to be used in one or more processes, and in particular to optimising the chilled water temperature.

A refrigeration cycle is utilised to chill water for use in one or more processes. The cycle includes an evaporator through which water to be chilled is passed and in which expanding coolant is utilised to draw heat from the water. The coolant is supplied to the evaporator over a coolant circuit containing a compressor, a condenser, and a control valve for controlling the amount of cooling effect.

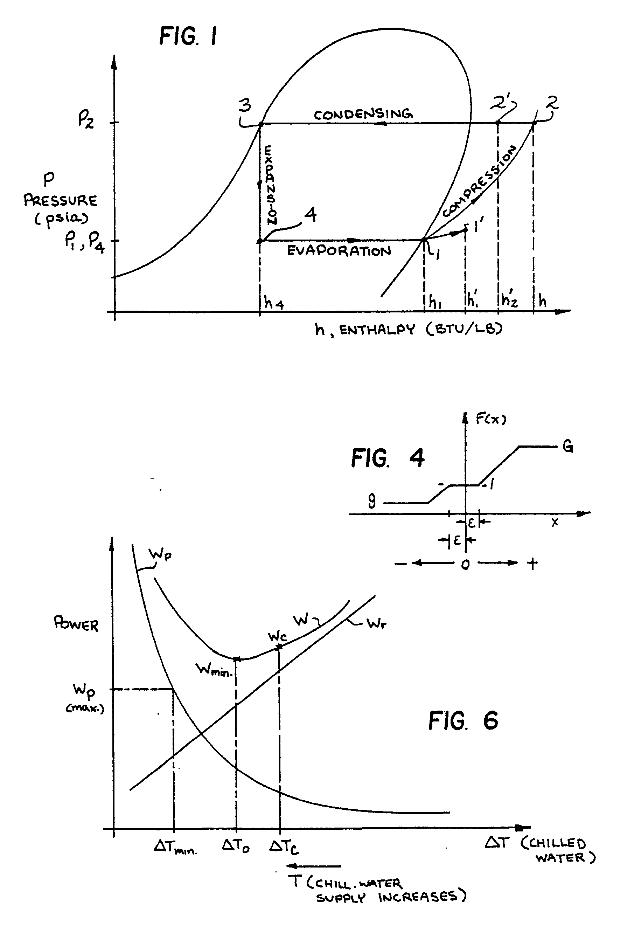

Figure 1 of the accompanying drawings shows a graph plotting the heat content of the coolant, that is the enthalpy thereof, against the coolant pressure. (In Figure 1, the coolant pressure is expressed in $lbf/in^2$ absolute (psia) and enthalpy is expressed in Btu/lb. It will be appreciated that the graph would in essence be the same if it were plotted in metric units). As shown in Figure 1, coolant is expanded in the evaporator from point 3 to point 4 which results in coolant evaporation from point 4 to point 1. Compression takes place from point 1 to point 2 and condensation of coolant from point 2 to point 3.

To conserve energy, it is desirable to optimise chilled water temperature by critically controlling the flow of coolant and the use of power in the coolant cycle as well as the chilled water cycle.

Supervisory control of optimum chilled water temperature is normally implemented by computers and extensive computer programs. Analog devices can also be utilised. However, the expected performance of these devices suffers. For example, accuracy and flexibility are reduced. Analog devices further cannot optimise the control operation.

Computers, on the other hand, require high-level language which takes relatively long to process within the computer. In addition, highly trained personnel are needed to program and to operate the computer devices. These all result in high costs.

A control system for minimizing the total energy consumed by an air conditioning system of a building is described in US—A—4327559 having a sensor for sensing the energy expended by the fan of the air conditioning system, a sensor for sensing the energy expended by the centrifugal chiller of the air conditioning system, and a controller responsive to the fan energy sensor and the chiller energy sensor for controlling the air conditioning system, so that the total energy consumed by the fan and chiller systems is minimized. The chiller energy is indirectly sensed by two temperature sensors for sensing refrigerant head across the chiller.

According to the present invention there is provided an arrangement for the optimized control of the temperature of chilled water supplied to at least one process by pump means, the water being chilled by coolant in a coolant cycle having compressor means and load valve means, the arrangement being characterised by:

a first temperature sensor for sensing a supply temnperature of the water to the process;

a second temperature sensor for sensing a return temperature of water from the process;

work determining means connected to the pump and compressor means for determining a total amount of work needed to chill and supply water to the process;

supervisory control means connected to the first and second temperature sensors and the work determining means for generating a reference temperature which is a function of the supply temperature and the ratio $\Delta W/\Delta(\Delta T)$, where $\Delta W$ is a change in the total amount of work with time and $\Delta(\Delta T)$ is a change in the difference between the supply and return temperatures, the reference temperature being equal to the supply temperature when the ratio is approximately zero, being less than the supply temperature when the ratio is negative and being more than the supply temperature when the ratio is positive; and

temperature control means connected to the supervisory control means for receiving the reference temperature, to the first temperature sensor for receiving the supply temperature, to the process for receiving a demand value, and to the load valve means for controlling the load valve means according to a load demand signal which corresponds to the difference between the supply temperature and the lowest of the reference temperature and the demand value.

The invention also provides a method of controlling the temeprature of chilled water to an optimum extent, which chilled water is supplied to at least one process by pump means, the water being chilled by a coolant in a coolant cycle having compressor means and load valve means, the method being characterised by:

sensing the supply temperature of chilled water supplied to the process;

sensing the return temperature of chilled water returned from the process;

determining a total amount of work expanded in chilling and supplying the chilled water to the process; and

generating a reference temperature for use to control the load valve means as a function of a multiple of the supply temperature and a multiplication factor, the multiplication factor being obtained on the basis of a ratio between a change $\Delta W$ in the total amount of work over a change $\Delta(\Delta T)$ in the difference between the supply and return temperatures, the multiplication factor being one when the ratio is about zero, less than one when the ratio is negative and more than one when the ratio is positive.

A preferred embodiment of the present invention described hereinbelow provides a performance level in the supervisory control of chilled water temperature which is equivalent to that which computers can deliver. However, the cost is low and is comparable to that of analog devices. The preferred embodiment also does not have the disadvantages of a relatively long processing time. Its speed is faster than that of computers and is also comparable to that of analog devices. The advantages of analog devices and computers are thus combined in the preferred embodiment.

The main concept of the preferred embodiment is to increase the chilled water supply temperature as long as the efficiency is increased or the cost of cooling per unit refrigeration, "ton", is decreased. The preferred embodiment stops changing the chilled water temperature when an optimum condition is obtained.

The preferred embodiment is simple in design, rugged in construction and economical to manufacture.

The invention will now be further described, by way of illustrative and non-limiting example, with reference to the accompanying drawings, in which:

Figure 1 is a graph of a cooling cycle plotting enthalpy against pressure in the cooling cycle;

Figure 2 is a schematic diagram illustrating a chilled water temperature control arrangement embodying the invention;

Figure 3 is a block diagram showing details of a supervisory control logic circuit or unit of the arrangement of Figure 2;

Figure 4 is a graph illustrating a function F(x) utilised to generate a reference temperature in the logic circuit of Figure 3;

Figure 5 is a block diagram of a control logic circuit for controlling a load demand valve of a coolant circuit illustrated in Figure 2; and

Figure 6 is a graph illustrating the optimum temperature difference between supply and reference temperatures for a chilled water circuit, and its relationship to the work expended in various parts of the arrangement.

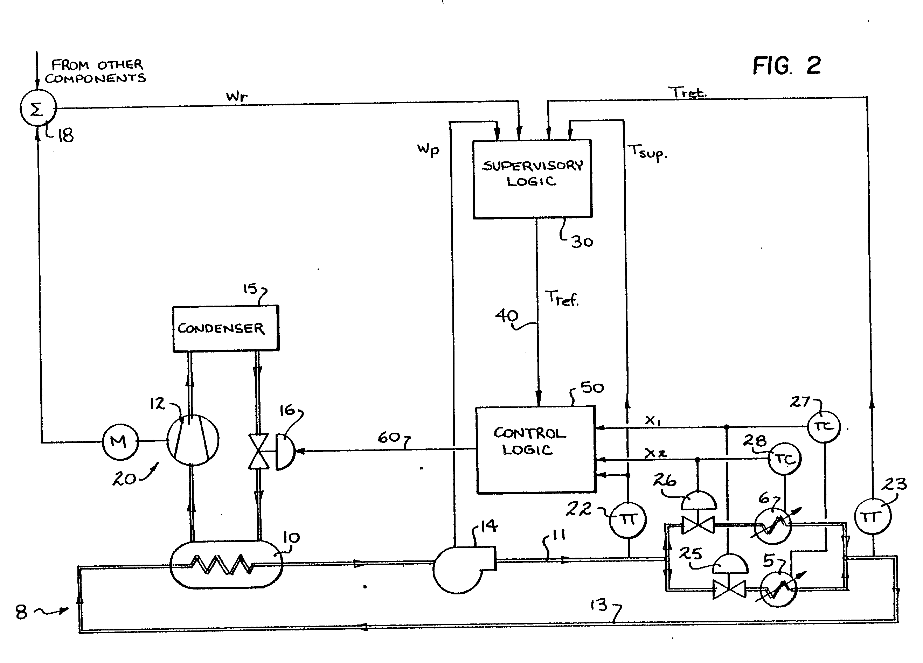

Figure 2 of the drawings shows an arrangement for the optimized control of chilled water supplied to one or more processes (illustratively two processes shown schematically at 5 and 6) over a chilled water cycle or circuit 8. The chilled water cycle 8 includes an evaporator 10, a pump 14, a supply line 11 and a return line 13. In known fashion, the evaporator 10 is connected to a coolant cycle or circuit 20 having a compressor 12 for compressing expanded and evaporated coolant from the evaporator 10, supplying it to a condensor 15 and returning it over a load valve 16 to the evaporator.

Each process 5, 6 includes a process valve 25 and 26, respectively, for passing a selected amount of chilled water from the chilled water cycle 8 to the process. TC controllers 27 and 28 control the respective valves 25 and 26 and also supply demand signals $x_1$ and $x_2$ to a temperature control unit (control logic) 50, to be described later.

A first temperature sensor 22 is connected to the chilled water feed line 11 for sensing the chilled water supply temperature $T_{sup}$. A second temperature sensor 23 is connected to the return line 13 for supplying a chilled water return temperature $T_{ret}$. The supply temperature $T_{sup}$ is provided to the temperature control unit 50 as well as to a supervisory control unit (supervisory logic) 30 which will also be described later. Also supplied to the supervisory control unit 30 is the return temperature value $T_{ret}$ as well as work values $W_r$ and $W_p$. The work value $W_p$ is the amount of work generated by the pump 14 and the value $W_r$ is the total amount of additional work required by the coolant cycle 20 as well as other peripheral work utilising devices such as cooling towers, other pumps and fans. This total value of additional work is determined in a summing unit 18.

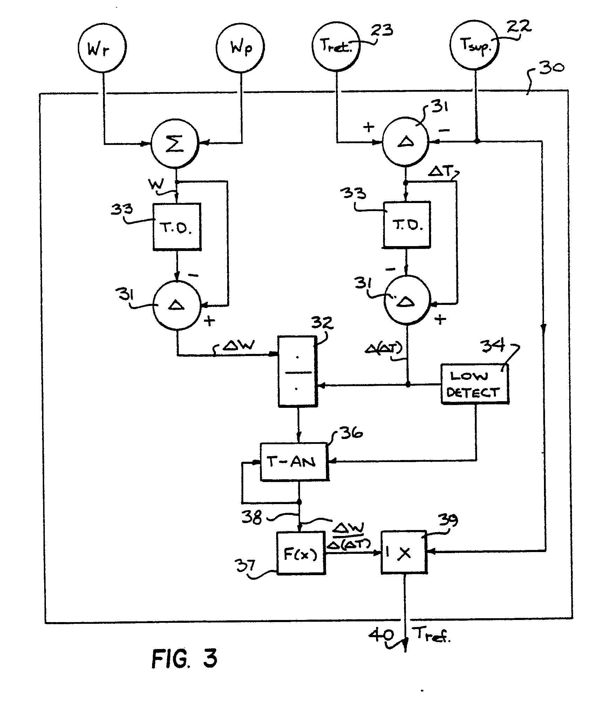

Referring to Figure 3, which shows details of the supervisory control unit 30, numerals 31 designate comparators which generate values equal to a difference between two inputs thereto, and numerals 33 designate time delays which are utilised to obtain a difference value over time.

In this way, a difference $\Delta T$ between the supply and return temperature is obtained, which temperature difference is read at two distinct times to obtain a difference $\Delta(\Delta T)$ in the temperature difference. This value is supplied as the denominator in a division unit 32. A numerator also supplied to the division unit 32 corresponds to the difference $\Delta W$ in total work used in chilling and supplying the chilled water to the one or more processes. Where the difference in temperature change falls below a selected limit, a low detector 34 provides a further signal to a calculator unit 36 to be used for a bumpless transfer in generating the ultimate value $\Delta W/\Delta(\Delta T)$ on a line 38. A function generator 37 (F(x)) is utilized, as described more fully below, to produce either a value 1, a value less than 1 or a value greater than 1 on its output and to provide this value to a multiplier 39. This value is than multiplied in the multiplier 39 by the supply temperature $T_{sup}$ form the sensor 22 and generates a reference temperature $T_{ref}$ on a line 40. The line 40 is connected to the temperature control logic and 50 which produces a load demand signal that controls the load valve 16 according to the optimum chilled water temperature.

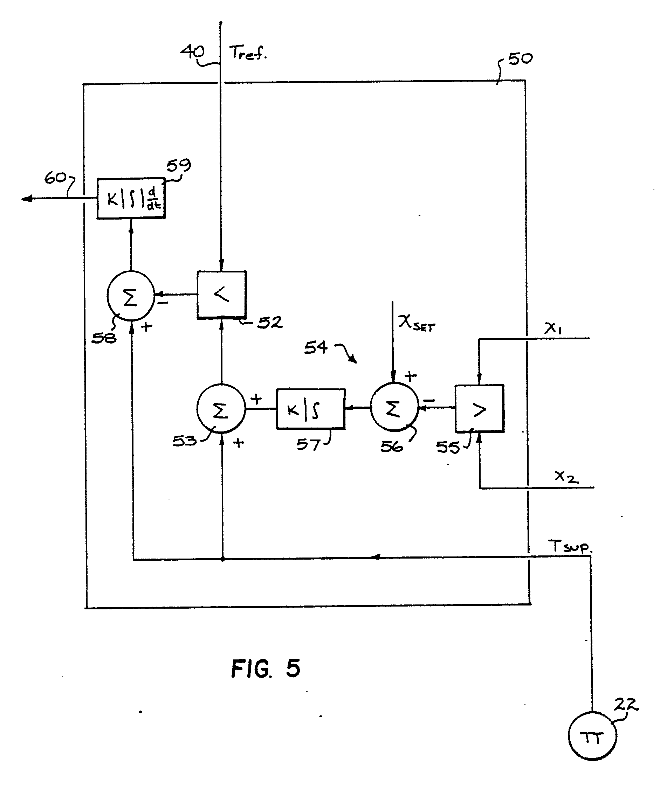

Figure 5 shows details of the temperature control logic unit 50. A low selector 52 receives the reference temperature value $T_{ref}$ from the supervisory control unit 30 over the line 40 and selects either that value or a value from a summing unit 53, if that value is lower. The summing unit 53 receives two inputs, one from the supply temperature sensor 22 and the other from a load demand arrangement generally designated 54. The load demand arrangement 54 includes a high selector 55 which is connected to receive the valve control signals $x_1$ and $x_2$ and select the greater value, designating greater valve opening position. This value is subtracted in a summing unit 56 from a set value $x_{set}$, corresponding to a 90% open position. The resulting value is supplied over a PI controller 57 to one input of the summing unit 53. The set value $x_{set}$ is a

manually-set signal indicative of maximum opening of valves (described by the valve control signals $x_1$ and $x_2$).

The output of the low selector 52 corresponds to a temperature set point $T_{set}$ or bias which is applied to a further summing unit 58 and subtracted from the supply temperature $T_{sup}$. The resultant difference corresponds to the optimum set point and is available over a PID controller 59 on a line 60 which leads to the load valve 16 for the coolant flow.

The structures illustrated in Figures 2, 3 and 4 as well as the graphs of Figures 1, 4 and 6 will now be utilised to explain the operation of the present arrangement.

Referring once more to Figure 1, a coefficient of performance (COP), a measure of efficiency, is defined by:

$$COP = \frac{\text{Refrigeration Output}}{\text{Power Input}} = \frac{h_1 - h_4}{h_2 - h_1} \tag{1}$$

An increase in the temperature of the chilled water leaving the evaporator 10 increases the temperature (and enthalpy) entering the compressor 12 (point 1'). Assuming everything remains the same, the COP' will be

$$COP' = \frac{h'_1 - h_4}{h_2 - h'_1} \tag{2}$$

It turns out the COP'>COP as shown in the following calculations.

Typical values for the chilled water cycle are:

$h_1 = 70.7$ Btu/lb (164.4 J/g); $P_1 = 5.4$ lbf/in$^2$ (37.2 kPa) absolute
$h_4 = 17.34$ Btu/lb (40.3 J/g); $P_4 = 5.4$ lbf/in$^2$ (37.2 kPa) absolute
$h_2 = 87.29$ Btu/lb (203.0 J/g); $P_2 = 51.94$ lbf/in$^2$ (358.1 kPa) absolute

so that:

$$COP = \frac{70.7 - 17.34}{87.29 - 70.7} \left( \frac{164.4 - 40.3}{203.0 - 164.4} \right) = \frac{53.26}{16.59} \left( \frac{124.1}{38.6} \right) = 3.22 \tag{3}$$

Increasing $T_1$ by 10°F (5.56°C), i.e. to the point 1', gives $h'_1 = 72.0$ lbf/in$^2$ (167.4 J/g) absolute, and:

$$COP' = \frac{72.0 - 17.34}{87.29 - 72.0} \left( \frac{167.4 - 40.3}{203.0 - 167.4} \right) = \frac{54.66}{15.29} \left( \frac{127.1}{35.6} \right) = 3.57 \tag{4}$$

Thus:

$$\frac{\Delta COP}{COP} = \frac{COP' - COP}{COP} = 0.108 \tag{5}$$

There is a 1.08% increase in COP for each 1°F (0.556°C) of temperature. That is, $(\Delta COP/COP) = 0.0108\Delta T$, where $\Delta T$ is in units of 1°F (0.556°C). A simplified equation for % decrease of power input (KW) can be written for % increase of COP:

$$\frac{-\Delta KW}{KW} \cong \frac{COP}{COP} = 0.0108\Delta T \tag{6}$$

which leads to:

$$\frac{(\Delta KW/KW)}{\Delta T} = -0.0108 \tag{7}$$

The values of $(\Delta KW/KW)\Delta T$ can be calculated from measurements and can be updated.

Example

Consider a chiller with a 1400 ton (1422.4 tonne) capacity and using the present arrangement. The temperature of the chilled water is increased by 10°F (5.556°C). The energy cost is US\$ 5/10⁶ Btu. COP=3.224 and the compressor and driving efficiency is n=0.72.

$$\text{The annual energy cost per ton}=\left(\frac{12000}{3.22}\right)\frac{8000}{0.72}\left(\frac{5}{10^6}\right)=\text{US\$ 206.}$$

The annual saving=206(1400)(0.0108)(10)=US\$ 31,147.

Alternately, using equation (7):

$$\text{Annual saving }=\Delta KW(3412)8000\frac{5}{10^6}$$

$$=0.0108(10)\frac{1400}{3.22}\frac{12000}{3412}\left[(3412)\frac{8000}{0.72}\frac{5}{10^6}\right]=\text{US\$ 31,147.}$$

The control strategy of the present arrangement is that the chilled water temperature is maximised while all users of the refrigeration plant are satisfied. This is done by keeping the most open valve of chilled water at 90 percent open. The 10 percent safety factor is left for operational safety and can be adjusted. There are other factors which may limit the maximisation of this temperature. This would be supervisory setting due to a higher level optimisation. In that case the maximum chilled water temperature will be dictated by this valve rather than the most open valve position.

As the chilled water supply temperature $T_{sup}$ is increased for improved efficiency while the return chilled water temperature $T_{ret}$ remains at its maximum allowable limit, the temperature difference $\Delta T$ is reduced. This means an increased flow to increase the overall heat transfer coefficient for the same load conditions. However, increased flow means increased pumping cost. An optimum trade-off exists between the increased cost of pumping and the decreased cost of refrigeration (mainly the compressor). The supervisory control of the present arrangement adjust the amount of chilled water temperature increases as shown in Figure 5($T_{ret}$).

The efficiency of a refrigeration system is defined as the ratio of heat removed $Q_c$, to the work W, required to remove the heat, or:

$$n=\frac{Q_c}{W}=n_e n_c \tag{8}$$

where:
$n_e$=equipment efficiency; and
$n_c$=cycle efficiency.
However, the cycle efficiency $n_c$ can be expressed as

$$n_c=\frac{T_r-T_0}{T_0}=\frac{\Delta T_r}{T_0} \tag{9}$$

where:
$T_r$=temperature (of coolant or refrigerant) at the condenser; and
$T_0$=temperature (of refrigerant) at the evaporator.
Combining the terms gives:

$$W_r=\frac{Q_c}{n}=\left(\frac{Q_c}{n_e T_0}\right)\Delta T_r=K_1\Delta T_r \tag{10}$$

As $\Delta T_r$ is decreased by increasing the chilled water temperature, W is decreased, as expected, for a given load and environment.
On the other hand, pump power can be described as

$$W_p=C_p m h \tag{11}$$

where:
$C_p$=a constant;
m=mass flow; and
h=head.

Knowing that $m=k\sqrt{h}$, $W_p$ becomes

$$W_p=Km^3 \qquad (12)$$

For the heat transfer $Q_e$ in the evaporator:

$$Q_e=C_e m \Delta T_w \qquad (13)$$

where:

$C_e$=a constant; and

T=temperature difference of chilled water supply and return.

Substituting into equation (12):

$$W_p=K\left(\frac{Q_eC_e}{\Delta T}\right)^3=K_p\left(\frac{1}{\Delta T}\right)^3 \qquad (14)$$

As the chilled water supply temperature is increased for a given chilled water return temperature, $\Delta T$ is decreased. This relation established a direct proportion between $\Delta T_r$ and $\Delta T$ and $\Delta T_r$ can be replaced by $\Delta T$, leading to:

$$W=W_r+W_p=K_r\Delta T+K_p\left(\frac{1}{\Delta T}\right)^3 \qquad (15)$$

Curves for $W$, $W_r$, $W_p$ are shown in Figure 6. Conventional values are $W_c$, $\Delta T_c$ for the total power and the temperature difference respectively. As $\Delta T$ decreases, an optimum $\Delta T$ is obtained at $\Delta T_0$ corresponding to $W_{min}$. At this point $T_{ref}$ is obtained to regulate the control logic of chilled water temperature optimisation.

Note that without supervisory control $\Delta T$ will stop at $\Delta T_{min}$ by the limit of $W_{p(max)}$ for the pump which corresponds to a total $W$ higher than $W_{min}$.

The supervisory control unit (supervisory logic) 30 of the present arrangement is shown in Figure 3. Referring to Figure 6, the general idea is to operate about the $\Delta T_0$ area for minimised power. If process load is reduced, $\Delta T$ will be made smaller until $\Delta T_0$ is reached. The values of $\Delta W/\Delta(\Delta T)$ will be calculated by the supervisory control unit (supervisory logic) 30 of Figure 3 and, whenever this value is about zero, $F(x)=1$ and $T_{ref}=T_{sup}$. See Figure 4 which illustrates the function $F(x)$. This will be the desired $\Delta T=\Delta T_0$. Now, examining Figure 5, the low selector 52 will allow $T_{set}=T_{ref}$ preventing any increase in the supply temperature $T_{sup}$ if demand is low. However, if cooling demand is high and the other input of the low selector 52 becomes lower than $T_{ref}$, then the decrease in $T_{sup}$ is permitted. If the output $\Delta W/\Delta(\Delta T)$ from the division unit 32 (Figure 3) is positive ($\Delta T>\Delta T_0$), then $F(x)=$a large number G (e.g. 3) and there is no effect from $T_{ref}$ to $T_{set}$. When $\Delta W/\Delta(\Delta T)$ is negative ($\Delta T<\Delta T_0$), $F(x)=$a small number g (e.g. 1/3), and $T_{ref}$ will be lower than the other signal at the low selector 52 and $\Delta T$ will be driven to $\Delta T_0$.

## Claims

1. An arrangement for the optimised control of the temperature of chilled water supplied to at least one process (5, 6) by pump means (14), the water being chilled by coolant in a coolant cycle (20) having compressor means (12) and load valve means (16), the arrangement being characterised by:

a first temperature sensor (22) for sensing a supply temperature ($T_{sup}$) of the water to the process (5, 6);

a second temperature sensor (23) for sensing a return temperature ($T_{ret}$) of water from the process (5, 6);

work determining means (14, 18) connected to the pump (14) and compressor means (12) for determining a total amount of work (W) needed to chill and supply water to the process (5, 6);

supervisory control means (30) connected to the first and second temperature sensors (22, 23) and the work determining means (14, 18) for generating a reference temperature ($T_{ref}$) which is a function of the supply temperature ($T_{sup}$) and the ratio $\Delta W/\Delta(\Delta T)$, where $\Delta W$ is a change in the total amount of work (W) with time and $\Delta(\Delta T)$ is a change in the difference between the supply and return temperatures ($T_{sup}$, $T_{ret}$), the reference temperature ($T_{ref}$) being equal to the supply temperature ($T_{sup}$) when the ratio is approximately zero, being less than the supply temperature when the ratio is negative and being more than the supply temperature when the ratio is positive; and

temperature control means (50) connected to the supervisory control means (30) for receiving the reference temperature ($T_{ref}$), to the first temperature sensor (22) for receiving the supply temperature ($T_{sup}$), to the process (5, 6) for receiving a demand value ($X_1$, $X_2$), and to the load valve means (16) for controlling the load valve means according to a load demand signal which corresponds to the difference between the supply temperature ($T_{sup}$) and the lowest of the reference temperature ($T_{ref}$) and the demand value.

2. An arrangement according to claim 1, wherein the work determining means includes a summing unit (18) connected to the compressor means (12) and to additional work using elements other than the pump means (14) for determining the total amount of work needed.

3. An arrangement according to claim 1 or claim 2, wherein the supervisory control means (30) comprises a first comparator (31) connected to the first and second temperature sensors (22, 23) for obtaining the difference $\Delta T$ between the supply and return temperatures ($T_{sup}$, $T_{ret}$), a delay unit (33) connected to an output of the first comparator (31), and is second comparator (31) connected to an output of the delay unit (33) for comparing the difference in temperature at one time with the difference in temperature at a later time to obtain the change in difference value $\Delta(\Delta T)$.

4. An arrangement according to claim 3, wherein the work determining means includes a summing unit for summing work from the pump means (14) and the compressor means (12), and the supervisory control means (30) includes a second delay unit (33) connected to an output of the summing unit, a third comparator (31) connected to an output of the second delay unit (33) for obtaining the change $\Delta W$, in the amount of total work W, and a division unit (32) for receiving the value $\Delta W$ and dividing it by the value $\Delta(\Delta T)$.

5. An arrangement according to claim 4, wherein the supervisory control means (30) includes a function generator (37) connected to an output of the division unit (32) for generating a value equal to one when the ratio is approximately equal to zero, a value less than one when the ratio is negative and a value greater than one when the ratio is positive, and a multiplier (39) connected to an output of the function generator (37) and connected to the first temperature sensor (22) for multiplying a value corresponding to the supply temperature ($T_{sup}$) by an output of the function generator to form the reference temperature ($T_{ref}$), a line (40) being connected between the supervisory control means (30) and the temperature control means (50) for carrying the reference temperature ($T_{ref}$) to the temperature control means from the supervisory control means (30).

6. An arrangement according to any one of the preceding claims, wherein the at least one process (5, 6) includes a process valve (25, 26) and a process valve controller (27, 28) for generating a valve setting, the temperature control means (50) including a summing unit (56) connected to the process valve controller (27, 28) and connected to receive the valve set point ($x_{set}$) corresponding to at least a 90% opening of a valve, the summing unit (55) obtaining a difference between the set point ($x_{set}$) and the setting of the process valve controller (27, 28), a further summing unit (53) connected to an output of the first-mentioned summing unit (56) and to the first temperature sensor (22) for obtaining a temperature set value, a low selector (52) connected to an output of the further summing unit (53) and to the supervisory control means (30) for receiving the reference temperature ($T_{ref}$), the low selector (52) selecting its lowest input and outputting the lowest input as a temperature set point, and a comparator (58) connected to the low selector (52) and to the first temperature sensor (22) for obtaining a difference between the temperature set point and the supply temperature ($T_{sup}$) to form an optimum set point, the comparator (58) being connected to the load valve means (16) for regulating the load valve means (16) according to the optimum set point.

7. A method of controlling the temperature of chilled water to an optimum extent, which chilled water is supplied to at least one process (5, 6) by pump means (14), the water being chilled by a coolant in a coolant cycle (20) having compressor means (12) and load valve means (16), the method being characterised by:

sensing the supply temperature ($T_{sup}$) of chilled water supplied to the process (5, 6);

sensing the return temperature ($T_{ret}$) of chilled water returned from the process;

determining a total amount of work (W) expanded in chilling and supplying the chilled water to the process; and

generating a reference temperature ($T_{ref}$) for use to control the load valve means (16) as a function of a multiple of the supply temperature ($T_{sup}$) and a multiplication factor, the multiplication factor being obtained on the basis of a ratio between a change $\Delta W$ in the total amount of work (W) over a change $\Delta(\Delta T)$ in the difference between the supply and return temperatures ($T_{sup}$, $T_{ret}$), the multiplication factor being one when the ratio is about zero, less than one when the ratio is negative and more than one when the ratio is positive.

8. A method according to claim 7, including determining the total amount of work (W) by adding the amount of work (Wp) utilised to operate the pump means (14) with the amount of work (Wr) utilised to operate the compressor means (12).

9. A method according to claim 7 or claim 8, including obtaining the difference between the supply and return temperatures ($T_{sup}$, $T_{ret}$) at a first point of time, waiting for a selected duration of time and obtaining the difference between the supply and return temperature ($T_{sup}$, $T_{ret}$) at a second point in time, and comparing the values obtained at the first and second points in time with each other to obtain the change $\Delta(\Delta T)$ in temperature difference.

10. A method according to claim 7, claim 8 or claim 9, including determining the total amount of work (W) at a first point in time, waiting a time delay period, obtaining the total amount of work at a second point in time, and comparing the amount of work at the first and second points in time to each other to obtain the change $\Delta W$ in the total amount of work (W).

# EP 0 127 265 B1

**Patentansprüche**

1. Anordnung für die optimierte Steuerung der Temperatur von gekühltem Wasser, welches mindestens einem Prozeß (5, 6) durch Pumpmittel (14) zugeführt ist, wobei das Wasser durch ein Kühlmittel in einem Kühlkreislauf (20) abgekühlt wird mit Kompressormitteln (12) und Lastventilmitteln (16), wobei die Anordnung gekennzeichnet ist durch:

einen ersten Temperatursensor (22) zum Abfühlen einer Zuführtemperatur ($T_{sup}$) des Wassers zu dem Prozeß (5, 6);

einen zweiten Temperatursensor (23) zum Abfühlen einer Rücklauftemperatur ($T_{ret}$) von Wasser aus dem Prozeß (5, 6);

Arbeitsbestimmungsmittel (14, 18), die mit dem Pumpen- (14) und Kompressormittel (12) verbunden sind zur Bestimmung eines Gesamtarbeitsbetrages (W), der zum Abkühlen und Zuführen von Wasser zu dem Prozeß (5, 6) benötigt wird;

Überwachungssteuermittel (30), die mit dem ersten und zweiten Temperatursensor (22, 23) und dem Arbeitsbestimmungsmittel (14, 18) zur Erzeugung einer Bezugstemperatur ($T_{ref}$) verbunden sind, welche Temperatur eine Funktion der Zuführtemperatur ($T_{sup}$) und des Verhältnisses $\Delta W/\Delta(\Delta T)$, wobei $\Delta W$ eine Änderung des Gesamtarbeitswertes (W) mit der Zeit und $\Delta(\Delta T)$ eine Veränderung in der Differenz zwischen der Zuführ- und Rücklauftemperatur ($T_{sup}$, $T_{ret}$) ist, wobei die Bezugstemperatur ($T_{ref}$) gleich der Zuführtemperatur ($T_{sup}$) ist, wenn das Verhältnis etwa 0 ist, kleiner als die zuführtemperatur ist, wenn das Verhältnis negativ ist, und größer als die Zuführtemperatur ist, wenn das Verhältnis positiv ist; und

Temperatursteuermittel (50), die mit dem Überwachungssteuermittel (30) verbunden sind für die Aufnahme der Bezugstemperatur ($T_{ref}$), mit dem ersten Temperatursensor (22) zur Aufnhame der Zuführtemperatur ($T_{sup}$), mit dem Prozeß (5, 6) zum Aufnehmen eines Bedarfswertes ($x_1$, $x_2$) und mit dem Lastventilmittel (16) verbunden ist zur Steuerung des Lastventilmittels entsprechend einem Lastbedarfssignal, welches der Differenz zwischen der Zuführtemperatur ($T_{sup}$) und dem kleinsten der Bezugstemperatur ($T_{ref}$) und des Bedarfswertes entspricht.

2. Anordnung nach Anspruch 1, wobei das Arbeitsbestimmungsmittel eine Summiereinheit (18) aufweist, die mit dem Kompressormittel (12) und mit zusätzlichen Arbeitsverwendungselementen außer dem Pumpmittel (14) verbunden ist für die Bestimmung des Gesamtbetrages der erforderlichen Arbeit.

3. Anordnung nach Anspruch 1 oder Anspruch 2, wobei das Überwachungssteuermittel (30) eine erste Vergleichsschaltung (31) aufweist, die mit dem ersten und zweiten Temperatursensor (22, 23) verbunden ist, zum Erhalten der Differenz $\Delta T$ zwischen der Zuführ- und Rücklauftemperatur ($T_{sup}$, $T_{ret}$), eine Verzögerungseinheit (33) mit einem Ausgang der ersten Vergleichsschaltung (31) verbunden ist und eine zweite Vergleichsschaltung (31) mit einem Ausgang der Verzögerungseinheit (33) verbunden ist für den Vergleich der Temperaturdifferenz gleichzeitig mit der Temperaturdifferenz zu einer späteren Zeit, um die Differenzwertveränderung $\Delta(\Delta T)$ zu erhalten.

4. Anordnung nach Anspruch 3, wobei das Arbeitsbestimmungsmittel eine Summiereinheit aufweist zum Summieren der Arbeit aus dem Pumpmittel (14) und dem Kompressormittel (12) und das Überwachungssteuermittel (30) eine zweite Verzögerungseinheit (33) aufweist, die mit einem Ausgang der Summiereinheit verbunden ist, eine dritte Vergleichsschaltung (31) aufweist, die mit einem Ausgang der zweiten Verzögerungseinheit (33) verbunden ist zum Erhalten der Änderung $\Delta W$ des Betrages der Gesamtarbeit W und eine Teilereinheit (32) aufweist für die Aufnahme des Wertes $\Delta W$ und seine Aufteilung durch den Wert $\Delta(\Delta T)$.

5. Anordnung nach Anspruch 4, wobei das Überwachungssteuermittel (30) einen Funktionsgenerator (37), der mit einem Ausgang der Teilereinheit (32) verbunden ist zur Erzeugung eines Wertes gleich Eins, wenn das Verhältnis nahe gleich 0 ist, eines Wertes kleiner als Eins, wenn das Verhältnis negativ ist, und eines Wertes größer als Eins, wenn das Verhältnis positiv ist, und einen Vervielfacher (39) aufweist, der mit einem Ausgang des Funktionsgenerators (37) verbunden ist und mit dem ersten Temperatursensor (22) verbunden ist zum Multiplizieren eines Wertes entsprechend der Zuführtemperatur ($T_{sup}$) mit einem Ausgang des Funktionsgenerators, um die Bezugstemperatur ($T_{ref}$) zu bilden, wobei eine Leitung (40) zwischen dem Überwachungssteuermittel (30) und dem Temperatursteuermittel (50) verbunden ist zum Führen der Bezugstemperatur ($T_{ref}$) zu dem Temperatursteuermittel aus dem Überwachungssteuermittel (30).

6. Anordnung nach einem der vorhergehenden Ansprüche, wobei der mindestens eine Prozeß (5, 6) ein Prozeßventil (25, 26) und eine Prozeßventilsteuereinrichtung (27, 28) aufweist zur Erzeugung einer Ventileinstellung, wobei das Temperatursteuermittel (50) eine Summiereinheit (56) aufweist, die mit der Prozeßventilsteuereinrichtung (27, 28) verbunden ist und angeschlossen ist, um einen Ventileinstellpunkt ($x_{set}$) zu erhalten entsprechend mindestens einer 90%-igen Öffnung eines Ventils, wobei die Summiereinheit (55) eine Differenz zwischen dem Einstellpunkt ($x_{set}$) und der Einstellung der Prozeßventilsteuereinrichtung (27, 28) erhält, eine weitere Summiereinheit (53) mit einem Ausgang der erstgenannten Summiereinheit (56) und mit dem ersten Temperatursensor (22) verbunden ist zum Erhalten eines Temperatureinstellwertes, ein Tiefenselektor (52) mit einem Ausgang der weiteren Summiereinheit (53) und mit dem Überwachungssteuermittel (30) verbunden ist zur Aufnahme der Bezugstemperatur ($T_{ref}$), wobei der Tiefenselektor (52) seinen tiefsten Eingang auswählt und den tiefsten Eingang als einen Temperatureinstellpunkt ausgibt, und wobei eine Vergleichsschaltung (58) mit dem Tiefenselektor (52) und dem ersten Temperatursensor (22) verbunden ist zum Erhalt einer Differenz zwischen dem Temperatureinstellpunkt und der Zuführtemperatur ($T_{sup}$), um einen optimalen Einstellpunkt zu bilden, wobei die Vergleichsschaltung (58) an dem Lastventilmittel (16) für die Regulierung des Lastventilmittels entsprechend dem optimalen Einstellpunkt angeschlossen ist.

7. Verfahren zur Steuerung der Temperatur von gekühltem Wasser in optimalem Umfang, wobei das gekühlte Wasser mindestens einem Prozeß (5, 6) durch Pumpmittel (14) zugeführt und durch ein Kühlmittel in einem Kühlkreislauf (20) mit Kompressormitteln (12) und Lastventilmitteln (16) gekühlt wird, gekennzeichnet durch:

das Abfühlen der Zuführtemperatur ($T_{sup}$) von gekühltem, dem Prozeß (5, 6) zugeführtem Wasser;

Abfühlen der Rücklauftemperatur ($T_{ret}$) von gekühltem, aus dem Prozeß zurückgeführtem Wasser;

Bestimmen eines Gesamtbetrages an Arbeit (W), die beim Abkühlen und Zuführen des abgekühlten Wassers zu dem Prozeß verbraucht wird; und

Erzeugen einer Bezugstemperatur ($T_{ref}$) zur Steuerung des Lastventilmittels (16) als Funktion eines Vielfachen der Zuführtemperatur ($T_{sup}$) und eines Multiplikationsfaktors, der auf der Basis eines Verhältnisses der Änderung $\Delta W$ im Gesamtbetrag der Arbeit (W) zu einer Veränderung $\Delta(\Delta T)$ in der Differenz zwischen der Zuführ- und Rücklauftemperatur ($T_{sup}$, $T_{ret}$) erhalten wird und 1 ist, wenn das Verhältnis etwa 0 ist, kleiner als 1 ist, wenn das Verhältnis negativ ist, und mehr als 1 ist, wenn das Verhältnis positiv ist.

8. Verfahren nach Anspruch 7, mit dem Bestimmen des Gesamtbetrages der Arbeit (W) durch Addieren des Betrages der Arbeit ($W_p$), die verwendet wird, um das Pumpmittel (14) zu betreiben, zum Betrag der Arbeit ($W_r$), die verwendet wird, um das Kompressormittel (12) zu betreiben.

9. Verfahren nach Anspruch 7 oder Anspruch 8, mit dem Erhalten der Differenz zwischen der Zuführ- und Rücklauftemperratur ($T_{sup}$, $T_{ret}$) zu einem ersten Zeitpunkt, Abwarten einer ausgewählten Zeitdauer und Erhalten der Differenz zwischen der Zuführ- und Rücklauftemperatur ($T_{sup}$, $T_{ret}$) zu einem zweiten Zeitpunkt und Vergleichen der zu dem ersten und zweiten Zeitpunkt erhaltenen Werte miteinander, um die Veränderung $\Delta(\Delta T)$ in der Temperaturdifferenz zu erhalten.

10. Verfahren nach Anspruch 7, Anspruch 8 oder Anspruch 9, mit dem Bestimmen des Gesamtbetrages der Arbeit (W) zu einem ersten Zeitpunkt, Abwarten einer Zeitverzögerungsperiode, Erhalten des Gesamtbetrages der Arbeit zu einem zweiten Zeitpunkt und Miteinandervergleichen des Arbeitsbetrages zu dem ersten und zweiten Zeitpunkt, um die Änderung $\Delta W$ im Gesamtbetrag der Arbeit (W) zu erhalten.

**Revendications**

1. Dispositif pour la commande optimalisée de la température d'eau refroidie délivrée à au moins un processus (5, 6) par une pompe (14), l'eau étant refroidie par un agent réfrigérant dans un cycle d'agent réfrigérant (20) possédant un compresseur (12) et une soupape de charge (16), le dispositif étant caractérisé par:

un premier capteur de température (22) en vue de détecter une température d'alimentation ($T_{sup}$) de l'eau au processus (5, 6);

un second capteur de température (23) en vue de détecter une température de retour ($T_{ret}$) d'eau du processus (5, 6);

un moyen de détermination de travail (14, 18) reccordé à la pompe (14) et un compresseur (12) en vue de déterminer une quantité totale de travail (W) nécessaire pour refroidir et délivrer de l'eau au processus (5, 6);

un moyen de commande centralisée (30) connecté aux premier et second capteurs de température (22, 23) et au moyen de détermination de travail (14, 18) en vue d'engendrer une température de référence ($T_{ref}$) qui est une fonction de la température d'alimentation ($T_{sup}$) et le rapport $\Delta W/\Delta(\Delta T)$, où $\Delta W$ est une variation de la quantité totale de travail (W) dans le temps et $\Delta(\Delta T)$ est une variation de la différence entre les températures d'alimentation et de retour ($T_{sup}$, $T_{ret}$), la température de référence ($T_{ref}$) étant égale à la température d'alimentation ($T_{sup}$) lorsque le rapport est approximativement zéro, étant inférieure à la température d'alimentation lorsque le rapport est négatif et étant supérieure à la température d'alimentation lorsque le rapport est positif; et

un moyen de commande de température (50) raccordé au moyen de commande centralisée (30) en vue de recevoir la température de référence ($T_{ref}$), au premier capteur de température (22) en vue de recevoir la température d'alimentation ($T_{sup}$) au processus (5, 6) en vue de recevoir une valeur de demande ($x_1$, $x_2$) et à la soupape de charge (16) pour commander la soupape de charge conformément à un signal de demande de charge correspondant à la différence entre la température d'alimentation ($T_{sup}$) et la plus faible de la température de référence ($T_{ref}$) et la valeur de demande.

2. Dispositif selon la revendication 1, dans lequel le moyen de détermination de travail comprend une unité de sommation (18) raccordée au compresseur (12), et à des éléments utilisant un travail supplémentaire autres que la pompe (14) en vue de déterminer la quantité totale de travail nécessaire.

3. Dispositif selon la revendication 1 ou la revendication 2, dans lequel les moyens de commande centralisée (30) comportent un premier comparateur (31) raccordé aux premier et second capteurs de température (22, 23) en vue d'obtenir la différence $\Delta T$ entre les températures d'alimentation et de retour ($T_{sup}$, $T_{ret}$), une unité de retard (33) raccordée à une sortie du premier comparateur (31), et un second

EP 0 127 265 B1

comparateur (31) raccordé à une sortie de l'unité de retard (33) en vue de comparer la différence de température à un instant à la différence de température à un instant plus tard pour obtenir la variation de valeur de différence Δ(ΔT).

4. Dispositif selon la revendication 3, dans lequel le moyen de détermination de travail comprend une unité de sommation en vue de sommer le travail de la pompe (14) et du compresseur (12), et le moyen de commande centralisée (30) comprend une seconde unité de retard (33) connectée à une sortie de l'unité de sommation, un troisième comparateur (31) connecté à une sortie de la seconde unité de retard (33) en vue d'obtenir la variation (ΔW) de la quantité de travail total W, et une unité de division (32) en vue de recevoir la valeur ΔW et de la diviser par la valeur Δ(ΔT).

5. Dispositif selon la revendication 4, dans lequel le moyen de commande centralisée (30) comprend un générateur de fonction (37) connecté à une sortie de l'unité de division (32) en vue d'engendrer une valeur égale à un lorsque le rapport est approximativement égal à zéro, une valeur inférieure à un lorsque le rapport est négatif et une valeur supérieure à un lorsque le rapport est positif, et un multiplicateur (39) connecté à une sortie du générateur de fonction (37) et connecté au premier capteur de température (22) en vue de multiplier une valeur correspondant à la température d'alimentation ($T_{sup}$) par une sortie du générateur de fonction pour former la température de référence ($T_{ref}$), un fil (40) étant relié entre le moyen de commande centralisée (30) et le moyen de commande de température (50) pour véhiculer la température de référence ($T_{ref}$) du moyen de commande centralisée (30) au moyen de commande de température.

6. Dispositif selon l'une quelconque des revendications précédentes, dans lequel l'un au moins des processus (5, 6) comprend une soupape de processus (25, 26) et un régulateur de soupape de processus (27, 28) en vue d'engendrer un réglage de soupape, le moyen de commande de température (50) comprenant une unité de sommation (56) connectée au régulateur de soupape de processus (27, 28) et connectée pour recevoir un point de consigne de soupape ($x_{cons}$) correspondant à au moins une ouverture à 90% d'une soupape, l'unité de sommation (55) obtenant une différence entre le point de consigne ($x_{cons}$) et le réglage du régulateur de soupape de processus (27, 28), une autre unité de sommation (53) connectée à une sortie de l'unité de sommation mentionnée en premier lieu (56) et au premier capteur de température (22) en vue d'obtenir une valeur de consigne de température, un sélecteur bas (52) connecté à une sortie de l'autre unité de sommation (53) et au moyen de commande centralisée (30) en vue de recevoir la température de référence ($T_{ref}$), le sélecteur bas (52) choisissant son entrée la plus basse et délivrant l'entrée la plus basse en tant que point de consigne de température, et un comparateur (58) connecté au sélecteur bas (52) et au premier capteur de température (22) en vue d'obtenir une différence entre la valeur de consigne de température et la température d'alimentation ($T_{sup}$) pour former un point de consigne optimal, le comparateur (58) étant connecté à la soupape de charge (16) en vue de réguler la soupape de charge selon le point de consigne optimal.

7. Procédé de commande de la température d'eau refroidie dans une mesure optimale, eau refroidie qui est fournie à au moins un processus (5, 6) par une pompe (14), l'eau étant refroidie par un agent réfrigérant dans un cycle d'agent réfrigérant (20) possédant un compresseur (12) et une soupape de charge (16), le procédé étant caractérisé par:

la détection de la température d'alimentation ($T_{sup}$) d'eau refroidie fournie au processus (5, 6);

la détection de la température de retour ($T_{ret}$) d'eau refroidie retournée depuis le processus;

la détermination d'une qunatité totale de travail (W) dépensée en refroidissement et en alimentation d'eau refroidie au processus; et

la génération d'une température de référence ($T_{ref}$) en vue d'une utilisation pour commander la soupape de charge (16) en fonction d'un multiple de la température d'alimentation ($T_{sup}$) et d'un facteur de multiplication, le facteur de multiplication étant obtenu à partir d'un rapport entre une variation ΔW de la quantité totale de travail (W) par rapport à une variation Δ(ΔT) de la différence entre les températures d'alimentation et de retour ($T_{sup}$, $T_{ret}$), le facteur de multiplication étant un lorsque le rapport est environ zéro, inférieur à un lorsque le rapport est négatif et supérieur à un lorsque le rapport est positif.

8. Procédé selon la revendication 7, comprenant la détermination de la quantité totale de travail (W) en ajoutant la quantité de travail ($W_p$) utilisée pour actionner la pompe (14) à la quantité de travail ($W_r$) utilisée pour actionner le compresseur (12).

9. Procédé selon la revendication 7 ou la revendication 8, comprenant l'obtention de la différence entre les températures d'alimentation et de retour ($T_{sup}$, $T_{ret}$) à un premier instant, l'attente pendant une durée de temps choisie et l'obtention de la différence entre la température d'alimentation et de retour ($T_{sup}$, $T_{ret}$) à un second instant, et la comparaison des valeurs obtenues aux premier et second instants entre elles pour obtenir la variation Δ(ΔT) de différence de température.

10. Procédé selon la revendication 7, la revendication 8 ou la revendication 9, comprenant la détermination de la quantité totale de travail (W) à un premier instant, l'attente pendant une période de retard de temps, l'obtention de la quantité totale de travail à un second instant, et la comparaison de la quantité de travail aux premier et second instants entre elles pour obtenir la variation ΔW de la quantité totale de travail (W).

FIG. 1

P
PRESSURE
(psia)

$P_2$

$P_1, P_4$

3    CONDENSING    2'    2

EXPANSION

4    COMPRESSION

EVAPORATION    1    1'

$h_4$    $h_1$    $h_1'$    $h_2'$    h

h, ENTHALPY (BTU/LB)

FIG. 4

F(x)

G

9    -1

$\epsilon$

$\epsilon$

x

−    0    +

FIG. 6

POWER

$W_P$

$W$    $W_r$

$W_c$

$W_{min.}$

$W_P$
(max.)

$\Delta T_{min.}$    $\Delta T_0$    $\Delta T_c$    $\Delta T$ (CHILLED WATER)

T (CHILL. WATER
SUPPLY INCREASES)

# FIG. 2

FIG. 3

FIG. 5